# EUROPEAN PATENT APPLICATION

(11) **EP 2 174 907 A2**
(43) Date of publication of application: **14.04.2010**
(21) Application number: 09171885.8
(22) Date of filing: 30.09.2009
(51) Int. Cl.: B81B 7/00

(54) **System and methods for implementing a wafer level hermetic interface chip**

(30) Priority: 08.10.2008 US 247368
(71) Applicant: Honeywell International Inc., Morristown, NJ 07962 (US)
(72) Inventor: Horning, Robert D., Morristown, NJ 07962-2245 (US); Willits, David S., Morristown, NJ 07962-2245 (US)
(74) Representative: Buckley, Guy Julian

(57) **Abstract**

Systems and methods for enabling hermetic sealing at the wafer level during fabrication of a microelectromechanical sensor (MEMS) device. The MEMS device has a specialized hermetic interface chip (HIC) that facilitates a stable hermetic sealing process. The HIC includes a plurality of vias (28) in a substrate layer, a plurality of mesas (20) having etched portions, a seal ring, a plurality of conductive leads (24) on a first side of the HIC, and a plurality of conductive leads (30) on a second side of the HIC. The plurality of conductive leads on the first side of the HIC feeds from the etched portions of the plurality of mesas through the plurality of vias in the substrate layer to the plurality of conductive leads on the second side of the HIC. The conductive leads are capable of connecting an external circuit to the MEMS device.

## Description

### BACKGROUND OF THE INVENTION

Many high performance MEMS devices, such as gyroscopes and accelerometers, are hermetically packaged in a vacuum or a gaseous environment. Hermetically sealing the substrate components within a MEMS device allows a vacuum or gas atmosphere to remain stable over time. Several MEMS device technologies today hermetically seal MEMS device substrates at the package level, after dicing of a sensing substrate wafer. This sealing typically occurs individually or in small batches during a separate fabrication processing step. A number of package level sealing (PLS) processes are utilized to hermetically seal MEMS devices, including: silicon to glass anodic bonding, silicon to silicon fusion bonding, and wafer to wafer bonding, utilizing various intermediate bonding agents.

PLS can lead to problematic effects such as stiction between a sensing wafer and substrate components during a bonding process and lower production yield of MEMS devices. To eliminate this waste and reduce other undesirable characteristics associated with PLS, several wafer level packaging (WLP) techniques have been implemented. WLP is a wafer-scale packaging technology where the resulting package can be identical in size to the actual die and where all die on a wafer are sealed at the same time. WLP allows for integration of wafer fabrication, packaging (including device interconnection), and testing at the wafer level. Typically, WLP has been implemented in the same substrate layers that form the MEMS device (e.g., amongst the glass and silicon substrate layers of an ordinary multi-layer MEMS gyroscope or accelerometer).

In practice, WLP design is difficult to implement due to higher non-recurring engineering costs, increased unit production costs, and various technological challenges associated with presently available WLP techniques. Also, WLP production quantities are usually not high enough to be economically feasible. Other difficulties associated with this form of WLP include: difficulty achieving a hermetic seal over the wafer topography, difficulty getting signal leads through the seal without creating leaks, difficulty with electrical shorts or parasitic effects, difficulty achieving vacuum during sealing, difficulty installing a getter for vacuum applications, and difficulty maintaining dimensional control of device features such as capacitive gaps.

### SUMMARY OF THE INVENTION

The present invention provides systems and methods for a hermetically sealed microelectromechanical sensor (MEMS) device. The hermetic sealing takes place at the wafer level during fabrication of the MEMS device. The MEMS device has a specialized hermetic interface chip (HIC) that facilitates a stable sealing process. An example HIC includes a plurality of vias in a substrate layer, a plurality of mesas having etched portions, a seal ring, a plurality of conductive leads connected to a first side of the HIC, and a plurality of conductive leads connected to a second side of the HIC. The plurality of conductive leads on the first side of the HIC feed from the etched portions of the plurality of mesas through the plurality of vias in the substrate layer to the plurality of conductive leads on the second side of the HIC.

In accordance with further aspects of the invention, the HIC includes at least one getter on a surface of the first side of the HIC, for creating ample gettering capacity in a vacuum atmosphere.

In accordance with further aspects of the invention, a MEMS device includes an HIC and a device component. The HIC having at least one via and at least one mesa. The device component having a first substrate layer, a mechanism device layer, and a second substrate layer. The HIC being hermetically sealed to the device component at the first substrate layer with a seal ring.

In accordance with further aspects of the invention, the fabrication of a MEMS device includes creating at least one via in a substrate layer of a hermetic interface chip (HIC), bonding a mesa layer to the substrate layer of the HIC, depositing conductive leads from at least one etched mesa to the at least one via, depositing a seal ring on the substrate layer of the HIC, and sealing the HIC to a device component at the seal ring.

In accordance with yet further aspects of the invention, the MEMS fabrication includes removing excess substrate material from mesa layer after bonding, such that the at least one etched mesa is independently bonded to the substrate layer of the HIC.

In accordance with other aspects of the invention, the fabrication includes aligning the seal ring of the HIC with a wetting film at the periphery of the device component and placing the at least one etched mesa into a hole in a substrate layer of the device component.

As will be readily appreciated from the foregoing summary, the invention provides for fabrication of a robust MEMS device that can be hermetically sealed at the wafer level. The MEMS device includes a HIC that facilitates a hermetic seal which maintains state-of-the-art gap control and increases production yield.

### BRIEF DESCRIPTION OF THE DRAWINGS

Preferred and alternative embodiments of the present invention are described in detail below with reference to the following drawings. These drawings only depict portions of an HIC and a device component of a MEMS device in accordance with various embodiments of the present invention:

FIGURE 1 illustrates a side cross-sectional view of a MEMS device in accordance with an embodiment of the present invention;

FIGURE 2 illustrates a bottom view of a HIC in accordance with an embodiment of the present invention;

FIGURE 3 illustrates a side cross-sectional view of a MEMS device during fabrication, in accordance with an embodiment of the present invention; and

FIGURE 4 illustrates a side cross-sectional view of a MEMS device in accordance with an embodiment of the present invention.

FIGURE 5 illustrates a side cross-sectional view of an HIC in accordance with an embodiment of the present invention.

FIGURE 6 illustrates a side cross-sectional view of a MEMS device in accordance with an embodiment of the present invention.

### DETAILED DESCRIPTION OF THE INVENTION

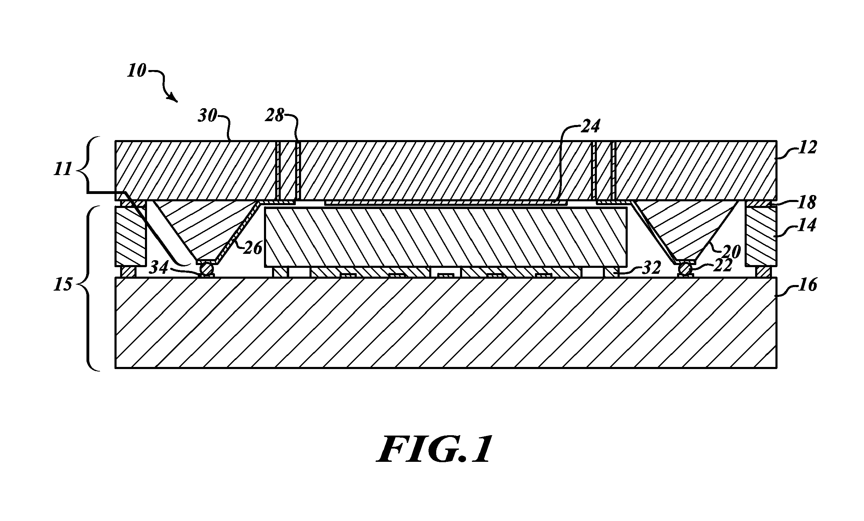

The present invention provides microelectromechanical sensor (MEMS) devices and fabrication processing methods for improving production yield by hermetically sealing a MEMS device with a hermetic interface chip (HIC) at the wafer level. Additionally, the MEMS devices and packaging techniques of the present invention eliminate almost all problems associated with presently available Wafer Level Packaging (WLP) techniques by hermetically sealing a MEMS device with an additional wafer, the HIC. FIGURE 1 illustrates a side cross-sectional view of a hermetically sealed MEMS device 10 in accordance with an embodiment of the invention. The MEMS device 10 includes a HIC 11 having an upper substrate layer 12, feedthrough vias 28, an outer seal ring 18, and etched substrate mesas 20; and a device component 15 having an upper substrate layer 14, a mechanism device layer 32, and a lower substrate layer 16 with bond pads 34. The HIC 11 further includes internal 26 and external 30 conductive leads connecting through the feedthrough vias 28, at least one getter component 24, and conductive interconnecting agents 22 disposed at the lower end of the etched substrate mesas 20.

The HIC 11 facilitates connection of the mechanism device layer 32 of the MEMS device 10 with the external leads 30 outside of the MEMS device during a hermetic sealing process. During fabrication, conductive interconnecting agents 22 are bonded to bond pads 34 to connect leads (not shown) emanating from the mechanism device layer 32 with the internal leads 26 disposed on the surface of the etched substrate mesas 20. The internal leads 26 on the substrate mesas 20 connect to the external leads 30 through a conductive trace included in the feedthrough vias 28. In an embodiment, the external leads 30 are made available for new packaging technologies such as flip-chip construction. Thus, the HIC 11 can act as an interface for additional chips such as analog application specific integrated circuits (ASIC) or digital signal processors (DSP).

In an embodiment, the etched substrate mesas 20 are formed of silicon and are pyramidal in shape. These mesas 20 are designed to fit inside of fabricated holes (e.g., ultrasonically drilled holes) in the upper substrate layer 14 of the device component 15. In one embodiment the upper substrate layer 14 and the lower substrate layer 16 of the device component 15 are formed of glass. In one embodiment, the upper substrate layer 12 of the HIC 11 can be formed of either glass or silicon. The internal leads 26 of the HIC 11 are patterned on the etched substrate mesas 20 to line up with the bond pads 34 on the lower substrate layer 16 of the device component 15. In an embodiment, each internal lead 26 disposed on the surface of an etched substrate mesa 20 terminates with the interconnecting agent 22, which is a solder ball that can be reflowed onto a bond pad 34 during a bonding process. The other end of the internal lead 26 terminates at the feedthrough vias 28.

In an embodiment, the outer seal ring 18 forms a continuous solder seal ring around the etched substrate mesas 20 and the at least one getter component 24. The solder ring hermetically seals around all openings between the upper substrate layer 12 of the HIC 11 and the upper substrate layer 14 of the device component 15. Because the feedthrough vias 28 go from the cavity space between the HIC 11 and the device component 15, through the upper substrate layer 12 of the HIC 11, rather than through the outer seal ring 18, there is no opportunity for electrical shorts or parasitics to occur.

Most of the non-mesa area inside the outer seal ring 18 of the HIC 11 remains unused. With this open chip topography, one or a plurality of getters 24 can be deposited anywhere within the non-mesa area of the HIC 11, thereby providing ample gettering capacity and a stable vacuum seal. A getter 24 is not needed in a gaseous atmosphere. Additionally, this open topography allows for the feedthrough vias 28 to be moved anywhere on the MEMS device 10.

There are multiple options for top side design of the HIC 11. In an embodiment, metal bond pads (not shown) can be patterned onto or near the feedthrough vias 28 on the top side of the upper substrate layer 12 of the HIC 11. These bond pads can be wire bonded to an external board or circuit such as an ASIC or DSP. In another embodiment, bump bonding balls are placed on the external leads 30 for flip chip bonding to an external board or circuit.

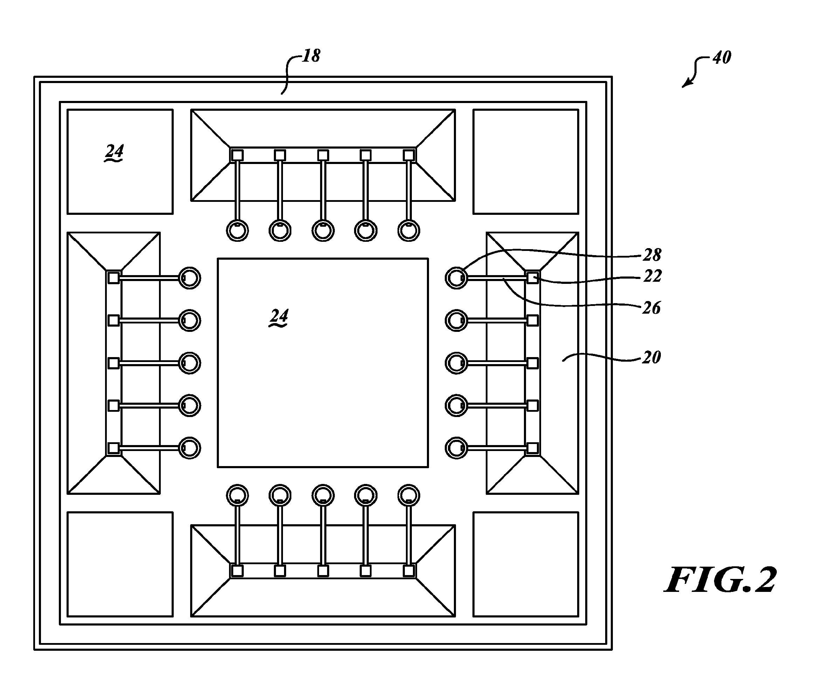

FIGURE 2 illustrates a bottom view of the HIC 40 in accordance with an embodiment of the present invention. The underside of the HIC 40 includes multiple etched substrate mesas 20, multiple getter components 24, the outer seal ring 18, and multiple feedthrough vias 28 connected to the conductive interconnecting agents 22, across the surface of the etched substrate mesas 20, with the internal leads 26.

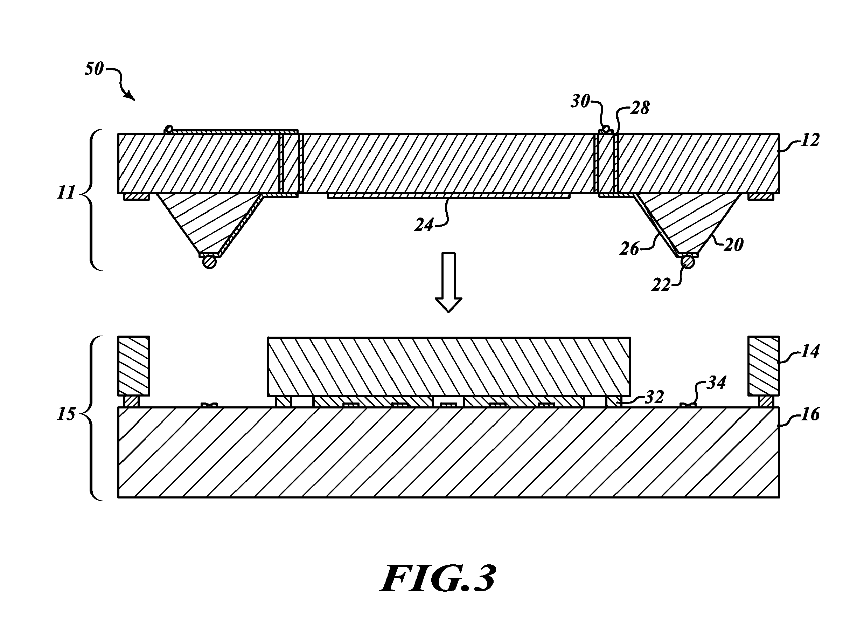

FIGURE 3 illustrates a side view of the MEMS device 50 during a fabrication processing step in accordance with an embodiment of the invention. During this processing step the HIC 11 is bonded to the upper substrate layer 14 of the device component 15 with the outer seal ring 18 on the upper substrate layer 12 of the HIC 11. Further, conductive interconnecting agents 22 on the surface of the etched substrate mesas 20 are bonded to the bond pads 34 on the lower substrate layer 16 of the device component 15, thereby creating a conductive path from the mechanism device layer 32 to the external conductive leads 30.

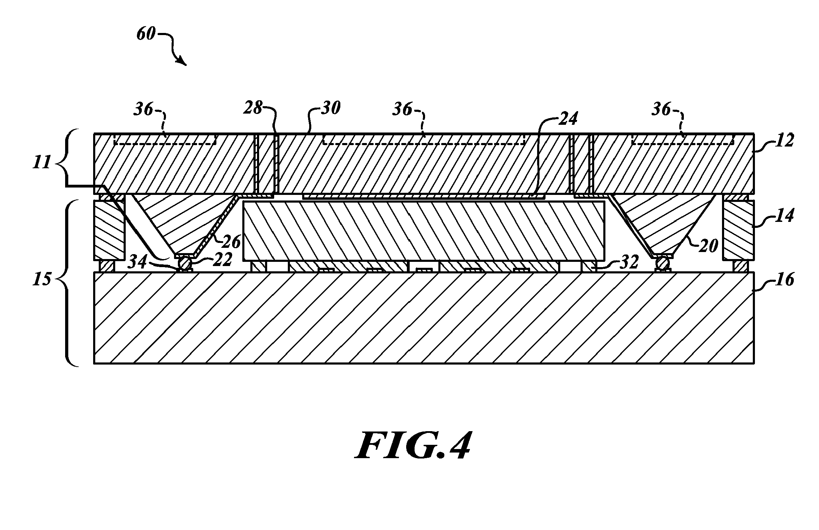

FIGURE 4 illustrates an embodiment of the invention where a MEMS device 60 includes integrated electronics 36 in the upper substrate layer 12 of an HIC 11. In this embodiment, the HIC 11 is formed of silicon and the integrated electronics 36 can be directly integrated into the silicon substrate. This integration can eliminate one or two levels of interconnections (e.g., wire or bump bonds), along with the noise and parasitics that typically accompany such interconnects. In another embodiment, the integrated electronics 36 include analog and/or digital components. Further, although the integrated electronics 36 are shown on the upper side of the HIC 11 (the non-mesa side), they could just as easily be integrated into the mesa side of the HIC 11.

In this embodiment, placement of the integrated electronics inside the cavity of the MEMS device 60 could advantageously eliminate another level of external interconnection. The integrated electronics 36 would need to be fabricated on a planar wafer, before bonding with the mesa wafer, or after bonding the mesa wafer but before etching the mesas 20. Aside from these modifications, the process would essentially remain the same as described above (i.e., the MEMS fabrication process where the HIC 11 is formed of a silicon substrate). Integrating electronics into the silicon substrate in this process would put limits on the maximum processing temperature (e.g., 450° C), but all the HIC process steps can be done at a lower temperature than that.

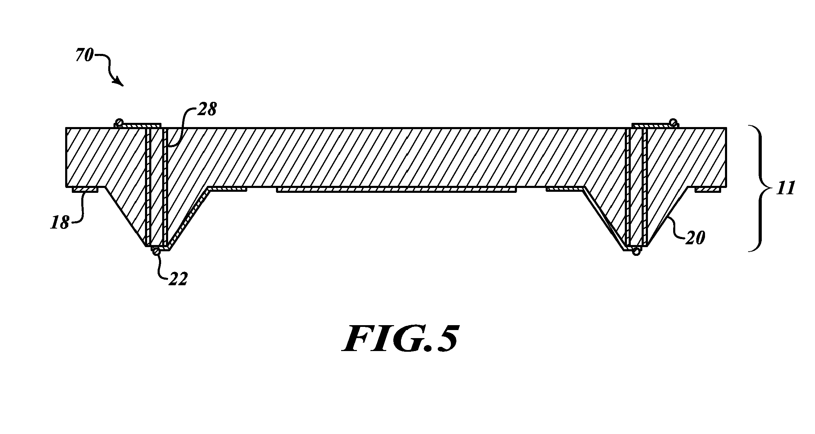

FIGURE 5 illustrates another embodiment of an HIC 11 of a MEMS device 70, where feedthrough vias 28 feed directly through the etched substrate mesas 20. In this configuration, there is no need for the internal leads 26 to be patterned on the mesas 20. Instead, the conductive traces of the feedthrough vias 28 terminate directly with interconnecting agents 22, which line up with the bond pads 34 on the lower substrate layer 16 of the device component 15.

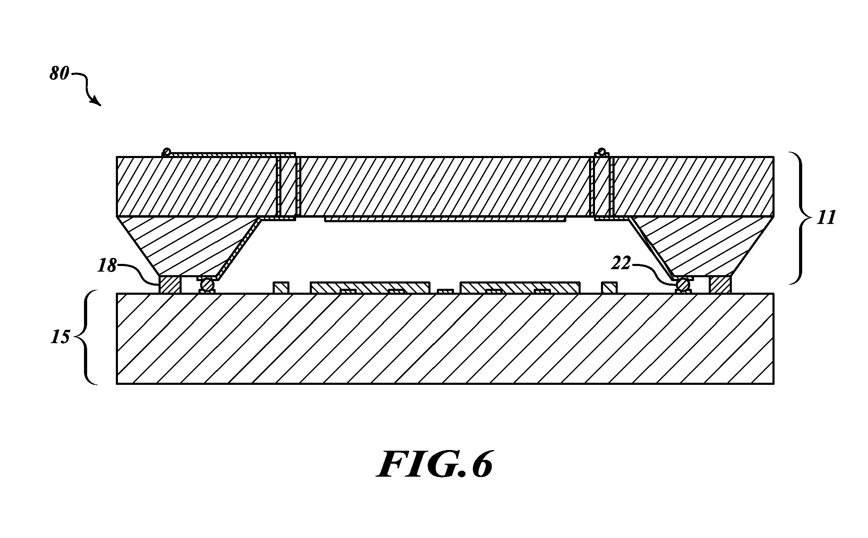

FIGURE 6 illustrates another embodiment of a device component 15 in a MEMS device 80. In this embodiment, the device component 15 does not include the upper substrate layer 14. The regions at the periphery of the lower substrate layer 16 are not covered by the mechanism device layer 32 and can be a hermetically sealed with the HIC 11 at the outer seal ring 18.

An example MEMS fabrication process for forming multiple MEMS devices in accordance with an embodiment of the present invention forms the upper substrate layer 12 of a HIC 11 of a silicon substrate which can be hermetically bonded with the upper substrate layer 14 of the device component 15. This process includes the following steps:
1) create a handle wafer of a silicon substrate with through silicon vias, polishing the surface on the underside (mesa side);
2) pattern the oxide to form an etch mask and then etch mesas in KOH or some other anisotropic etchant (stop etching on the oxide layer at the interface between the wafers);
3) deposit metal leads and bond pads on the lower and upper sides of the HIC;
4) deposit getters on the lower side of the HIC;
5) deposit a solder seal ring around the periphery edge on the lower side of the HIC;
6) deposit solder balls on the lower side of the etched mesas;
7) align the HIC to the device component, place the HIC onto the device component, and reflow the solder seal ring and the solder balls;
   a) in an alternate embodiment, the HIC can be anodically bonded to the upper device wafer in this step, thereby eliminating step 8;
8) deposit solder balls on the top side of the HIC in preparation for bonding to an external circuit; and
9) separate dies of multiple MEMS devices using known separation techniques (e.g., sawing).

Another example of a MEMS fabrication process for forming the upper substrate layer 12 of a HIC 11 of a silicon substrate which can be hermetically bonded with the upper substrate layer 14 of the device component 15. This process includes the following steps:
1) create a handle wafer of a silicon substrate with through silicon vias, polishing the surface on the underside (mesa side);
2) oxidize a second silicon wafer;
3) fusion bond the two wafers together to form a combined wafer (the HIC);
4) pattern the oxide to form an etch mask and then etch mesas in KOH or some other anisotropic etchant (stop etching on the oxide layer at the interface between the wafers);
5) deposit metal leads and bond pads on the lower and upper sides of the HIC;
6) deposit getters on the lower side of the HIC;
7) deposit a solder seal ring around the periphery edge on the lower side of the HIC;
8) deposit solder balls on the lower side of the etched mesas;
9) align the HIC to the device component, place the HIC onto the device component, and reflow the solder seal ring and the solder balls;
   a) in an alternate embodiment, the HIC can be anodically bonded to the upper device wafer in this step, thereby eliminating step 8;
10) deposit solder balls on the top side of the HIC in preparation for bonding to an external circuit; and
11) separate dies of multiple MEMS devices using known separation techniques (e.g., sawing).

An example of a MEMS fabrication process for forming multiple MEMS devices in accordance with another embodiment of the present invention includes an HIC formed of a glass substrate that can be hermetically bonded with an upper substrate layer of a device component. This process includes the following steps:
1) create a handle wafer of an anodically bondable glass substrate (e.g., Borofloat) with through-wafer vias;
2) deposit metal leads and bond pads on the lower and upper sides of the glass wafer. In an embodiment this step can be skipped if all the leads can be deposited and patterned after the mesas are in place;
3) oxidize a silicon wafer whose thickness is about the same as the thickness of the upper glass wafer (of the MEMS device);
4) pattern the oxide mask and KOH etch the mesas into the silicon wafer. The remaining silicon will hold the wafer together before bonding, and be removed after bonding. This will minimize the exposure of the metal on the glass wafer to KOH (or EDP or any of the other anisotropic etchants);
5) anodically bond the silicon wafer to the glass wafer forming a combined wafer (HIC);
6) etch away any remaining silicon, leaving only mesas bonded to the glass wafer component of the HIC;
7) deposit an oxide over the mesa side of the HIC to provide insulation between the subsequent metal leads. The oxide is patterned to expose the metal leads on the glass component of the HIC;
8) deposit metal leads up the sides of and onto the tops of the mesas;
9) deposit getters onto the lower side of the HIC;
10) deposit a solder seal ring onto the lower side of the HIC;
11) deposit solder balls on the lower side of the etched mesas;
12) align the HIC to the device component, place into contact, and heat to reflow the solder seal ring and the solder balls;
13) deposit solder balls on the top side of the HIC in preparation for bonding to an external circuit; and
14) separate dies of multiple MEMS devices using known separation techniques (e.g., sawing).

The embodiments of the invention in which an exclusive property or privilege is claimed are defined as follows:

## Claims

1. A hermetic interface chip (HIC), comprising:
a plurality of vias (28);
a plurality of substrate mesas (20) having etched portions on a first side of the HIC;
a seal ring (18); and
a plurality of conductive leads (30) on a second side of the HIC,
wherein the plurality of vias include a plurality of conductive traces (26) that feed from the first side of the HIC to the second side of the HIC.

2. The HIC device of Claim 1, further comprising at least one getter (24) on a surface of the first side of the HIC, for creating ample gettering capacity in a vacuum atmosphere.

3. The HIC device of Claim 1, wherein the plurality of vias go through the plurality of substrate mesas.

4. The HIC device of Claim 1, wherein the seal ring is positioned at a periphery edge on the first side of the HIC, around the plurality of substrate mesas and the at least one getter.

5. The HIC device of Claim 1, wherein an HIC substrate is formed of glass or silicon.

6. A method of fabricating a microelectromechanical sensor (MEMS) device, comprising:
creating at least one via in a substrate layer of a hermetic interface chip (HIC);
bonding a mesa layer to the substrate layer of the HIC;
depositing conductive leads from at least one etched mesa to the at least one via;
depositing a seal ring on the substrate layer of the HIC; and
sealing the HIC to a device component at the seal ring.

7. The method of Claim 6, further comprising removing excess substrate from the mesa layer after bonding, such that the at least one etched mesa is independently bonded to the substrate layer of the HIC and depositing at least one getter on a surface of the substrate layer.

8. The method of Claim 6, wherein sealing the HIC to the device component further comprises aligning the seal ring of the HIC with a wetting film at the periphery of the device component.

9. The method of Claim 6, wherein sealing the HIC to the device component further comprises heating the seal ring such that the seal ring acts as a bonding agent between the HIC and the device component.

10. The method of Claim 13, wherein the substrate layer of the HIC is formed of glass or silicon.
